# EUROPÄISCHE PATENTSCHRIFT

(11) **EP 0 360 349 B1**
(45) Veröffentlichungstag und Bekanntmachung des Hinweises auf die Patenterteilung: **22.01.1997**
(21) Anmeldenummer: 89202355.7
(22) Anmeldetag: 18.09.1989
(51) Int. Cl.: H03B 21/00, H03L 7/099, H03B 21/02

(54) **Digitaler Frequenzgenerator**
Digital frequency generator
Générateur de fréquence numérique

(30) Priorität: 22.09.1988 DE 3832152
(43) Veröffentlichungstag der Anmeldung: 28.03.1990
(73) Patentinhaber: Philips Patentverwaltung GmbH, 22335 Hamburg (DE); Philips Electronics N.V., 5621 BA Eindhoven (NL)
(72) Erfinder: Weber, Hubert, Dipl.-Ing. (FH), D-8501 Kalchreuth (DE); Thamm, Volker, Dipl.-Ing., D-8500 Nürnberg 10 (DE)
(74) Vertreter: Peuckert, Hermann, Dipl.-Ing.

(56) Entgegenhaltungen:
- EP-A- 0 140 042
- US-A- 2 881 320
- ELECTRONICS LETTERS, Band 11, Nr. 22, 30. Oktober 1975, Seiten 540-541; J.D.H. ALEXANDER: "Logical phase-controlled oscillator"
- IDEM

## Beschreibung

Die Erfindung betrifft einen digitalen Frequenzgenerator nach Oberbegriff des Anspruchs 1.

Aus ELECTRONIC LETTERS, Vol.11, No.22, 30. Oktober 1975, Seiten 540, 541, J.D.H. ALEXANDER, "Logical phase-controlled oscillator", ist ein digitaler Frequenzgenerator bekannt, bei dem die Summen- bzw. Differenzfrequenz zweier Taktsignale gebildet wird. Hierzu werden n-phasenverschobene Taktsignale des ersten Taktsignals benötigt, welche aus einem n-fach höheren Eingangssignal, beispielsweise mittels eines Ringzähler abgeleitet werden. Die n phasenverschobenen ersten Taktsignale sind auf die Eingänge eines Multiplexers geführt. Ein ebenfalls n-fach höheres zweites Eingangssignal wird als Taktsignal für einen Zähler verwendet, dessen Zählzustände zur Ansteuerung der Datenauswahl des Multiplexers verwendet werden. Je nach Zählrichtung (aufwärts bzw. abwärts) erhält man so am Ausgang des Multiplexers die Summen- bzw. Differenzfrequenz der beiden Taktsignale. Durch das Zusammensetzen des neuen Taktsignals aus den phasenverschobenen Anteilen des ersten Taktsignals weist das zusammengesetzte Taktsignal eine verbesserte spektrale Reinheit auf.

Die spektrale Reinheit des Ausgangssignales ist um so besser je größer die Anzahl n der phasenverschobenen Takte gewählt werden kann. Dies setzt aber auch voraus, daß die zu addierenden bzw. subtrahierenden Frequenzen als entsprechend n-fach höhere Frequenzen zur Verfügung stehen, was nicht immer der Fall sein wird.

Aufgabe der Erfindung ist es daher, eine Schaltungsanordnung der eingangs genannten Art anzugeben, bei der das zu addierende bzw. subtrahierende Taktsignal nicht als Vielfaches seiner Frequenz vorzuliegen braucht.

Diese Aufgabe wird durch die kennzeichnenden Merkmale des Anspruchs 1 gelöst.

In einer bevorzugten Ausführungsform wird ein erstes Taktsignal dem Phasenschieber zugeführt, der jeweils n um 1/n-Periodendauer phasenverschobene Ausgangssignale erzeugt, die dem Multiplexer zugeführt sind und daß ein zweites Taktsignal einem ersten Steuereingang des Zählers zugeführt ist, dessen Ausgänge mit Steuereingang des Multiplexers verbunden sind.

Die Erfindung wird nun an Hand eines in der Zeichnung dargestellten Ausführungsbeispieles näher beschrieben und erläutert.

Es zeigen:
Fig. 1 ein Ausführungsbeispiel der Erfindung,
Fig. 2 Spannungs-Zeit-Diagramme zu Fig. 1.
Fig. 3 ein weiteres Ausführungsbeispiel der Erfindung,
Fig. 4 weitere Spannungs-Zeit-Diagramme zu Fig. 3.

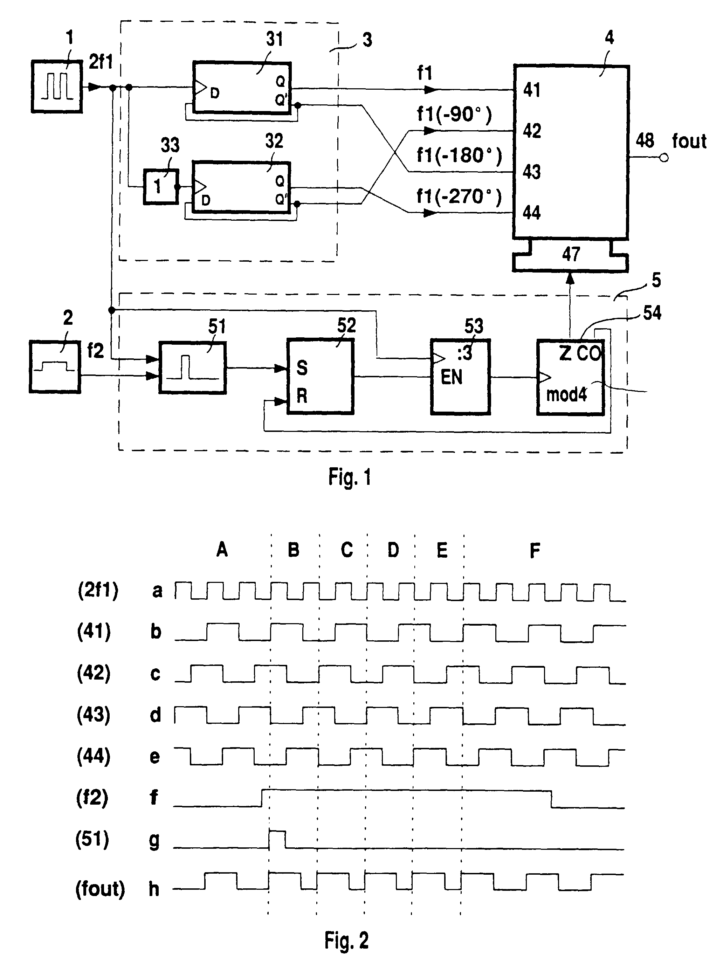

In Fig. 1 ist eine bevorzugte Ausführungsform der Erfindung dargestellt. Ein erster Taktgeber 1 und ein zweiter Taktgeber 2 erzeugen zwei Taktsignale 2f1 und f2. Der zeitliche Verlauf des ersten Taktsignales 2f1 ist in Fig. 2, Zeile a, der des zweiten Taktsignales f2 in Fig. 2, Zeile f dargestellt. Das Taktsignal des ersten Taktgebers 2f1 ist dem Eingang eines Phasenschiebers 3 zugeführt. Im Ausführungsbeispiel besteht der Phasenschieber 3 aus einem ersten und einem zweiten D-Flip-Flop 31 und 32 und einem Inverter 33. Jedes D-Flip-Flop 31, 32 weist einen Takteingang, einen D-Eingang, einen nichtinvertierenden Ausgang Q und einen invertierenden Ausgang Q′ auf. Das Taktsignal des ersten Taktgebers 1 ist dem Takteingang des ersten D-Flip-Flops 31 direkt und dem Takteingang des zweiten D-Flip-Flops 32 über den Inverter 33 zugeführt. Die nichtinvertierenden Ausgänge Q′ eines jeden D-Flip-Flops 31, 32 sind jeweils mit dem D-Eingang des gleichen Flip-Flops verbunden. Die an den Ausgängen der D-Flip-Flops 31, 32 abnehmbaren Taktsignale weisen auf diese Weise nur die halbe Frequenz des an ihren Eingängen angelegten Taktsignales auf. Bezogen auf das am nichtinvertierenden Ausgang des ersten D-Flip-Flops 31 abnehmbare Taktsignal f1 ist das am invertierenden Ausgang Q′ des zweiten D-Flip-Flops 32 abnehmbare Taktsignal f1(-90°) um 90° in der Phase, das am invertierenden Ausgang Q′ des ersten D-Flip-Flops 31 abnehmbare Taktsignal f1(-180°) um 180 in der Phase und das am nichtinvertierenden Ausgang Q des zweiten D-Flip-Flops 32 abnehmbare Taktsignal f1(-270°) um 270° in der Phase nacheilend. In den Zeilen b bis e der Fig. 2 ist der zeitliche Verlauf dieser vier Taktsignale dargestellt. Diese vier Taktsignale sind in dieser Reihenfolge ersten, zweiten, dritten und vierten Eingängen 41, 42, 43, 44 eines Multiplexers 4 zugeführt. Durch entsprechende Ansteuerungen von Adreßeingängen 47 des Multiplexers 4 ist jeweils eines aus diesen Phasenverschobenen Taktsignalen auswählbar.

Das erste Taktsignal 2f1 des ersten Taktgebers 1 sowie das zweite Taktsignal des zweiten Taktgebers f2 sind einer Ablaufsteuerung 5 zugeführt. Im Ausführungsbeispiel besteht diese Ablaufsteuerung aus einem Impulswandler 51, einem RS-Flip-Flop 52, einem Hilfszähler 53 und einem Adreßzähler 54. Dem Impulswandler sind die Taktsignale 2f1 und f2 des ersten und des zweiten Taktgebers 1, 2 zugeführt. Der Impulswandler 51 synchronisiert das zweite Taktsignal f2 mit dem ersten Taktsignal 2f1, wobei gleichzeitig die Impulslänge des zweiten Taktsignales f2 auf die Länge eines Impulses des ersten Taktsignales begrenzt wird. In Fig. 2, Zeile f ist der Zeitverlauf deß Taktsignales f2 dargestellt und darunter in Zeile g der Ausgang des Impulswandlers 51 abnehmbare Steuerimpuls. Der Steuerimpuls ist dem Seteingang 5 des RS-Flip-Flops 52 zugeführt. Der Ausgang des RS-Flip-Flops 52 ist mit einem Enable-Eingang EN des Hilfszählers 53 verbunden. Dem Takteingang des Hilfszählers ist das erste Taktsignal 2f1 des ersten Taktgebers 1 zugeführt. Nach jeweils drei Taktflanken erzeugt der Hilfszähler 53 einen Ausgangsimpuls, welcher an den Eingang des Adreßzählers 54 weitergeleitet ist. Die Zählausgänge Z des Adreßzählers 54 sind mit den Adreßeingängen 47 des Multiplexers 4 verbunden. Der Adreßzähler 54 ist ein Modulo-4-Zähler, welcher beim Übergang vom Zählzustand Drei auf den Zählzustand Null an einem Übertragsausgang CO einen Carry-Impuls abgibt, welcher einem Reset-Eingang R des RS-Flip-Flops 52 zugeführt ist.

Solange der Ausgangstakt des zweiten Taktgebers 2 nicht aktiv ist (Phase A in Fig. 2), ist das RS-Flip-Flop 52 zurückgesetzt und der Adreßzähler 54 befindet sich im Zählzustand Null. Hierdurch ist der erste Eingang 41 des Multiplexers 4 an seinen Ausgang 45 durchgeschaltet. Sobald das Taktsignal f2 in seinen aktiven Zustand wechselt, erzeugt der Impulswandler 51 einen Steuerimpuls, welcher das RS-Flip-Flop 52 setzt. Hierdurch wird der Hilfszähler aktiviert. Nach jeweils drei Taktflanken des ersten Taktsignales 2f1 wird durch das Ausgangssignal des Hilfszählers 53 der Adreßzähler 54 um jeweils einen Zählzustand weitergeschaltet. Nach Durchlaufen aller vier Zählzustände wird durch den Übertragsimpuls des Adreßzählers 54 das RS-Flip-Flop 52 bis zum Eintreffen eines neuen Impulses des Impulsgebers 51 zurückgesetzt. Durch die Zählzustände des Adreßzählers 54 sind auf diese Weise nacheinander der erste Eingang 41 (in den Phasen A und B), der Zweite Eingang 42 (in Phase C), der dritte Eingang 43 (in Phase D), der vierte Eingang 44 (in Phase E) und wieder der erste Eingang 41 (in Phase F) des Multiplexers an seinen Ausgang durchgeschaltet. Hierdurch wird das Ausgangssignal fout nacheinander aus den Phasenverschobenen Taktsignalen gebildet. Die Fig. 2, Zeile h, zeigt das Ausgangssignal fout. Aus dem Signalverlauf ist ersichtlich, daß in den Phasen B, C, D, E jeweils die Low-Phasen des Ausgangstaktsignales um die Hälfte verkürzt worden sind, und auf diese Weise während der Zeitdauer dreier Perioden des Taktsignales vier verkürzte Perioden entstanden sind. Auf diese Art und Weise kann der Signalverlauf homogenisiert werden und zwischenzeitlich höhere Frequenzanteile sind in ihrer Frequenz herabgesetzt.

Je größer die Anzahl n der durch den Phasenschieber erzeugbaren Phasenverschobenen Taktsignale ist, umso geringer wird die durch die Addition des zweiten Taktsignales verursachte Inhomogenität des Ausgangssignales. Hierzu muß der Adreßzähler soviele Zustände aufweisen wie dies der Anzahl n der erzeugten phasenverschobenen Taktsignale entspricht. Der Hilfszähler muß jeweils nach um die um Eins verminderte Anzahl n-1 der phasenverschobenen Taktsignale abgelaufenen Taktflanken einen Ausgangsimpuls erzeugen.

Durch ein Vertauschen der Eingänge des Multiplexers in umgekehrter Reihenfolge bzw. durch Umkehr der Zählrichtung des Adreßzählers wird anstelle der Summe der beiden Taktsignale f1 und f2 die Differenz der beiden Taktsignale gebildet. Auch bei der Subtraktion dieser beiden Taktsignale wird in vorteilhafter Weise ein homogener Signalverlauf erreicht.

Bei dem beschriebenen Ausführungsbeispiel entsprach die Anzahl der Eingänge des Multiplexers 4 der Anzahl der vom Phasenschieber 3 erzeugten phasenverschobenen Ausgangssignale. Der Aufbau des Hilfßzählers 53, der sowohl steigende als auch fallende Taktflanken zählt, ist unter Umständen, vor allem bei hohen Frequenzen, etwas aufwendig.

In einer weiteren Ausführungsform ist die Anzahl der Eingänge des Multiplexers 4 größer als die Anzahl der phasenverschobenen Ausgangssignale des Phasenschiebers 3. Einige Eingänge des Multiplexers sind hierbei mehrfach mit dem gleichen Eingangssignal belegt.

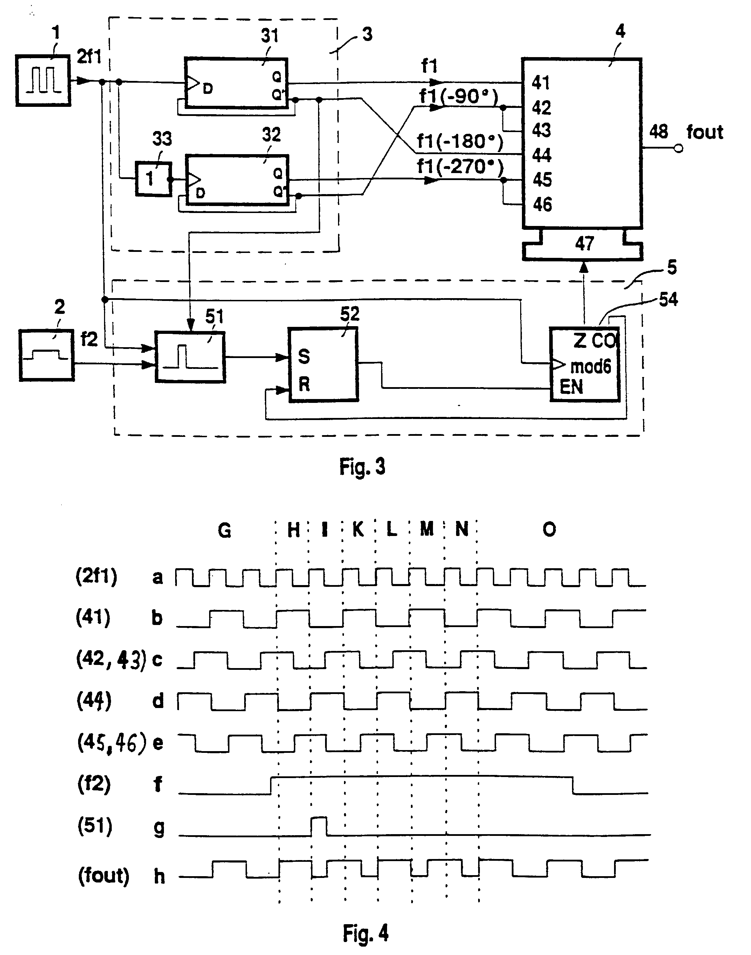

Fig. 3 zeigt hierzu ein Ausführungsbeispiel, dessen Schaltungsanordnung, soweit im folgenden nicht ausdrücklich beschrieben, der Schaltungsanordnung des in Fig. 1 dargestellten Ausführungsbeispieles entspricht.

In diesem Ausführungsbeispiel weist der Multiplexer 4 sechs Eingänge 41, 42, 43, 44, 45, 46 auf. Der erste Eingang 41 des Multiplexers 4 ist wieder mit dem nichtinvertierenden Ausgang des ersten D-Flip-Flops 31 verbunden. Dem zweiten und dritten Eingang 42, 43 des Multiplexers 4 ist jeweils das diesem Signal um 90° in der Phase nacheilende Taktsignal f(-90°) zugeführt. Dem vierten Eingang 44 des Multiplexers 4 ist das um 180° in der phase nacheilende Taktsignal f1(-180°) und dem fünften und sechsten Eingang 45, 46 das um 270° in der Phase nacheilende Taktsignal f1(-270°) zugeführt. Wegen der sechs Eingänge ist der Adreßzähler 54 diesmal als Modulo-6-Zähler ausgeführt.

Bei dieser Schaltungsanordnung entfällt ein Hilfszähler. Als Taktsignal ist dem Adreßzähler 54 das Ausgangssignal 2f1 des Taktgebers 1 zugeführt. Der Enable-Eingang EN des Adreßzählers 54 ist mit dem Ausgang des RS-Flip-Flops 52 verbunden. Weiterhin ist dem Impulsgeber 51 das um -180° in der Phase nacheilende Signal f1(-180°) zugeführt. Der Impulsgeber 51 ist nun so aufgebaut, daß er nach jeder steigenden Taktflanke des Ausgangssignales f2 des zweiten Taktgebers 2 genau dann einen Ausgangsimpuls abgibt, wenn das um 180° in der Phase nacheilende Taktsignal f1(-180°) eine steigende Taktflanke aufweist. Der Adreßzähler 54 wird mit jeder steigenden Taktflanke des Taktsignales 2f1 des ersten Taktgebers weiter geschaltet. Dies geschieht zum ersten Mal in der Phase E wenn das Taktsignal des Impulsgebers 51, dargestellt in Fig. 4, Zeile g, das RS-Flip-Flop setzt und somit der Enable-Eingang des Zählers 54 freigegeben wird. Der Zähler 54 durchläuft dann alle sechs Zählstufen, wobei jeweils der betreffende Eingang an den Ausgang des Multiplexers 4 durchgeschaltet wird. Nach Ablauf der sechs Zählstände wird der Zählerstand des Adreßzählers 54 wieder auf Null zurückgesetzt und der Ausgangsimpuls an seinem Übertrags-Ausgang CO setzt das RS-Flip-Flop 52 zurück. Auf diese Weise wird in den Phasen G und H jeweils das Taktsignal f1, in den Phasen 1 und K jeweils das um -90° in der Phase nacheilende Taktsignal f1, in der Phase L das um 180° in der Phase nacheilende Taktsignal f1(-180°) und in den phasen M und N das um 270° in der Phase nacheilende Taktsignal f1(-270°) und schließlich in der Phase 0 wieder das Taktsignal f1 an den Ausgang 48 des Multiplexers 4 durchgeschaltet.

In der Zeile h der Fig. 4 ist das aus diesen einzelnen Phasen zusammengesetzte Ausgangssignal des Multiplexers 4 dargestellt. Es entspricht genau dem Ausgangssignal des Multiplexers 4 des ersten Ausführungsbeispieles. Der Aufwand der zusätzlichen Eingänge für den Multiplexer ist geringer als der Aufwand für einen Hilfszähler, der auf diese Weise eingespart werden kann. Ansonsten bleiben die bereits geschilderten Vorteile erhalten.

In einer weiteren in der Figur nicht dargestellten Ausführungsform wird ein Multiplexer verwendet, dessen Anzahl der Eingänge genau der Anzahl der erzeugten Phasenverschobenen Signale entspricht. Als Adreßzähler wird ein Zähler mit einer Anzahl von Zählzuständen gewählt, die größer ist als die Anzahl der Eingänge des Multiplexers. In Multiplexern sind bauartbedingt Adreßcodierlogiken angeordnet, die je nach anliegendem Adreßsignal den diesem Adreßsignal zugeordneten Eingang an den Ausgang durchschalten. Bei dieser Ausführungsform ist die Adreßcodierlogik des Multiplexers so ausgebildet, daß sie für verschiedene Zählerzustände bestimmte Eingänge des Multiplexers mehrmals auswählt. So wird beim Adreßsignal Null der erste Eingang, bei den Adreßsignalen Eins und Zwei der zweite Eingang, bei dem Adreßsignal Drei der dritte Eingang und bei den Adreßsignalen Vier und Fünf der vierte Eingang zum Durchschalten an den Ausgang ausgewählt. Auf diese Weise kann das Ausgangssignal des Multiplexers wie im zweiten Ausführungsbeispiel ebenfalls ohne Hilfszähler zusammengestellt werden. Von Vorteil ist bei dieser Lösung, daß die Anzahl der Eingänge des Multiplexers gering gehalten werden kann.

Eine weitere in der Figur nicht dargestellte Abwandlung dieser zuletztgenannten Ausführungsform besteht darin, einen Zähler zu wählen, dessen Anzahl der Zählzustände die Anzahl der Eingänge des Multiplexers entspricht. Mittels einer Schaltlogik wird der Zähler bei bestimmten Zählzuständen für mindestens einen Takt am Weiterzählen gehindert, so daß wieder das gewünschte Ausgangssignal erhalten wird.

## Patentansprüche

1. Digitaler Frequenzgenerator zur Bildung eines Taktsignals (fout) aus einem ersten und einem zweiten Taktsignal (2fl, f2) mit einer Anordnung (3) zur Erzeugung von n um das 1/n-fache ihrer Periodendauer phasenverschobenen Signalen (fl, fl(-90°), fl(-180°), fl(-270°)) aus dem ersten Taktsignal (2f1), wobei die n phasenverschobenen Signale (fl, fl(-90°), fl(-180°), fl(-270°)) einem Multiplexer (4) zugeführt werden, der von einem Zähler (54) gesteuert wird,
dadurch gekennzeichnet,
daß die Taktfrequenz des Zählers (54) aus dem ersten Taktsignal (2f1) generiert wird und
daß ein Zählvorgang des Zählers (54) in Abhängigkeit vom zweiten Taktsignal (f2) gestartet wird.

2. Digitaler Frequenzgenerator nach Anspruch 1,
dadurch gekennzeichnet,
daß Mittel (51) zur Erzeugung eines Steuerimpulses (g) aus einem Impuls des zweiten Taktsignals (f2) vorgesehen sind,
daß der Steuerimpuls (g) mit dem ersten Taktsignal (2f1) oder einem der n phasenverschobenen Signale (f1(-180°)) synchronisiert wird und
daß der Steuerimpuls (g) ein Starten eines Zählvorgangs des Zählers (54) bewirkt.

3. Digitaler Frequenzgenerator nach Anspruch 1 oder 2,
dadurch gekennzeichnet,
daß der Multiplexer (4) n Eingänge (41, 42, 43, 44) aufweist, die zum Empfang jeweils eines der n phasenverschobenen Signale (f1, f1(-90°), f1(-180°), f1(-270°)) dienen.

4. Digitaler Frequenzgenerator nach einem der Ansprüche 1 bis 3,
dadurch gekennzeichnet,
daß ein ausgangsseitig mit dem Takteingang des Zählers (54) verbundener Hilfszähler (53) vorgesehen ist und
daß der Takteingang des Hilfszählers (53) zum Empfang des ersten Taktsignals (2f1) dient.

5. Digitaler Frequenzgenerator nach Anspruch 1 oder 2,
dadurch gekennzeichnet,
daß der Takteingang des Zählers (54) zum Empfang des ersten Taktsignals (2f1) vorgesehen ist.

6. Digitaler Frequenzgenerator nach Anspruch 1, 2, 4 oder 5,
dadurch gekennzeichnet,
daß der Multiplexer (4) mehr als n Eingänge (41, ..., 46) aufweist und
daß vorgesehen ist, mindestens eines der n phasenverschobenen Signale (f1(-90°) mindestens zwei Eingängen (42, 43) des Multiplexers (4) zuzuführen.

7. Digitaler Frequenzgenerator nach einem der Ansprüche 1 bis 6,
dadurch gekennzeichnet,
daß ein bistabiles Kippglied (52) vorgesehen ist, das in einem seiner beiden Zustände ein Zählen des Zählers (54) bewirkt.

8. Digitaler Frequenzgenerator nach einem der Ansprüche 1 bis 7,
dadurch gekennzeichnet,
daß der Zähler (54) zur Erzeugung eines Rückstellsignals dient, das ein Anhalten des Zählers (54) bis zur Erzeugung des nächsten Steuerimpulses (g) bewirkt.

9. Digitaler Frequenzgenerator nach Anspruch 8,
dadurch gekennzeichnet,
daß das Rückstellsignal zum Kippen des Kippgliedes (52) dient.

10. Digitaler Frequenzgenerator nach einem der Ansprüche 1 bis 9,
dadurch gekennzeichnet,
daß der Adreßzähler (54) eine der Anzahl der Eingänge des Multiplexers (4) entsprechende Anzahl von Zählzuständen aufweist.

## Claims

1. A digital frequency generator for forming a clock signal (fout) from a first and a second clock signal (2f1, f2), comprising an arrangement (3) for generating n signals (f1, f1(-90°), f1(-180°), f1(-270°)) phase-shifted by 1/n times their period duration relative to the first clock signal (2f1), the n phase-shifted signals (f1, f1(-90°), f1(-180°), f1(-270°)) being supplied to a multiplexer (4) which is controlled by a counter (54), characterized in that the clock frequency of the counter (54) depends on the first clock signal (2fl) and in that a counting operation is started depending on the second clock signal (f2).

2. A digital frequency generator as claimed in Claim 1, characterized in that means (51) for generating a control pulse (g) from a pulse of the second clock signal (f2) are provided, in that the control pulse (g) is synchronized with the first clock signal (2f1) or with one of the n phase-shifted signals (f1(180°)) and in that the control pulse (g) causes a counting operation of the counter (54) to start.

3. A digital frequency generator as claimed in Claim 1 or 2, characterized in that the multiplexer (4) has n inputs (41, 42, 43, 44) which are used each for receiving one of the phase-shifted output signals (f1, f1(-90°), f1(-180°), f1(-270°)).

4. A digital frequency generator as claimed in one of the Claims 1 to 3, characterized in that an auxiliary counter (53) is connected to the clock input of the counter (54) and in that the clock input of the auxiliary counter (53) is used for receiving the first clock signal (2f1).

5. A digital frequency generator as claimed in Claim 1 or 2, characterized in that the clock input of the counter (54) is used for receiving the first clock signal (2f1).

6. A digital frequency generator as claimed in Claim 1, 2, 4 or 5, characterized in that the multiplexer has more than n inputs (41, ..., 46) and in that at least one of the n phase-shifted signals (f1(-90°)) is applied to at least two inputs (42, 43) of the multiplexer (4).

7. A digital frequency generator as claimed in Claim 1 to 6, characterized in that a bistable multivibrator (52) in one of its two states causes the counter (54) to count.

8. A digital frequency generator as claimed in Claim 1 to 7, characterized in that the counter (54) is used for generating a reset signal which causes the counter (54) to stop until the next control pulse (g) is generated.

9. A digital frequency generator as claimed in Claim 8, characterized in that the reset signal is used for making the multivibrator (52) turn over.

10. A digital frequency generator as claimed in Claims 1 to 9, characterized in that the address counter (54) has a number of counts that corresponds to the number of inputs of the multiplexer (4).

## Revendications

1. Générateur de fréquence numérique destiné à former un signal d'horloge (fout) à partir d'un premier et d'un deuxième signaux d'horloge (2f1, f2) comportant un montage (3) destiné à générer à partir du premier signal d'horloge (2f1)n signaux (f1, f1(-90°), f1(-180°), f1(-270°)) déphasés de 1/n fois sa période, où les n signaux déphasés (f1, f1(-90°), f1(-180°), f1(-270°)) sont appliqués à un multiplexeur (4), qui est commandé par un compteur (54), caractérisé en ce que la fréquence d'horloge du compteur (54) dépend du premier signal d'horloge (2f1), et qu'une opération de comptage du compteur (54) est amorcée en fonction du deuxième signal d'horloge (f2).

2. Générateur de fréquence numérique suivant la revendication 1, caractérisé en ce que des moyens (51) destinés à générer une impulsion de commande (g) à partir d'une impulsion du deuxième signal d'horloge (f2) sont prévus, que l'impulsion de commande (g) est synchronisée avec le premier signal d'horloge (2f1) ou un des n signaux déphasés (f1(-180°)), et que l'impulsion de commande (g) provoque un amorçage d'une opération de comptage du compteur (54).

3. Générateur de fréquence numérique suivant la revendication 1 ou 2, caractérisé en ce que le multiplexeur (4) comporte n entrées (41, 42, 43, 44), qui servent à la réception de chacun des n signaux déphasés (f1, f1(-90°), f1(-180°), f1(-270°)).

4. Générateur de fréquence numérique suivant l'une quelconque des revendications 1 à 3, caractérisé en ce qu'un compteur auxiliaire (53), dont la sortie est connectée à l'entrée d'horloge du compteur (54), est prévu, et que l'entrée d'horloge du compteur auxiliaire (53) sert à la réception du premier signal d'horloge (2f1).

5. Générateur de fréquence numérique suivant la revendication 1 ou 2, caractérisé en ce que l'entrée d'horloge du compteur (54) est prévue pour la réception du premier signal d'horloge (2f1).

6. Générateur de fréquence numérique suivant la revendication 1, 2, 4 ou 5, caractérisé en ce que le multiplexeur (4) comporte plus de n entrées (41, ..., 46), et qu'il est prévu d'appliquer au moins un des n signaux déphasés (f1(-90°)) à au moins deux entrées (42, 43) du multiplexeur (4).

7. Générateur de fréquence numérique suivant l'une quelconque des revendications 1 à 6, caractérisé en ce qu'il est prévu une bascule bistable (52), qui provoque, dans un de ses deux états, un comptage du compteur (54).

8. Générateur de fréquence numérique suivant l'une quelconque des revendications 1 à 7, caractérisé en ce que le compteur (54) sert à générer un signal de remise à zéro, qui provoque un arrêt du compteur (54) jusqu'à la génération de l'impulsion de commande suivante (g).

9. Générateur de fréquence numérique suivant la revendication 8, caractérisé en ce que le signal de remise à zéro sert à faire basculer la bascule (52).

10. Générateur de fréquence numérique suivant l'une quelconque des revendications 1 à 9, caractérisé en ce que le compteur d'adresse (54) comporte un nombre d'états de comptage correspondant au nombre d'entrées du multiplexeur (4).
